Europäisches Patentamt

European Patent Office

Office européen des brevets

(19)

(11) Veröffentlichungsnummer: **0 189 210**
A2

# (12) EUROPÄISCHE PATENTANMELDUNG

(21) Anmeldenummer: 86100938.9

(22) Anmeldetag: 24.01.86

(51) Int. Cl.⁴: **H 01 K 1/08,** C 23 C 14/48, H 01 J 9/02 // H05B3/12

(30) Priorität: 24.01.85 BG 68522/85

(43) Veröffentlichungstag der Anmeldung: 30.07.86 Patentblatt 86/31

(84) Benannte Vertragsstaaten: **AT DE FR GB IT SE**

(71) Anmelder: **CUV "PROGRES", 125, Boul. Lenin Block 2, Sofia (BG)**

(72) Erfinder: **Kolev, Kolyo Zonev, 24-D, Dzerjinski Strasse, Sofia (BG)**
Erfinder: **Drandarov, Novak Dinev, Block 5-B Komplex Mladost-1, Sofia (BG)**
Erfinder: **Jetchev, Dimo Zahariev, Block 19/710 Quartal Darvenitza, Sofia (BG)**
Erfinder: **Stoyanov, Stoyan Borissov, 109, Tzar Samuil Strasse, Sofia (BG)**
Erfinder: **Jirov, Georgi Mihaylov, Block 73-6 Komplex Mladost-1, Sofia (BG)**

(74) Vertreter: **von Füner, Alexander, Dr. et al, Patentanwälte v. Füner, Ebbinghaus, Finck Mariahilfplatz 2 & 3, D-8000 München 90 (DE)**

(54) Verfahren zur Herstellung von Licht- und Wärmequellen mit verbesserter Ausstrahlfähigkeit.

(57) Gegenstand der Erfindung ist ein Verfahren zur Herstellung von Licht- und Wärmequellen mit verbesserter Ausstrahlfähigkeit, dadurch gekennzeichnet, dass man chemische Elemente als Ionen in eine entsprechende Unterlage in an sich bekannter Weise implantiert. Die Implantation wird im Vakuum von mehr als $10^{-4}$ Torr durchgeführt. Die Menge der implantierten Ionen beträgt $10^{10}$ bis $10^{23}$ Ionen/cm². Die Ionenstromdichte beträgt $10^{-8}$ bis 1 A/cm². Die Eindringtiefe des implantierten Ions erreicht $10^{-7}$ cm. Die Energie der Implantation beträgt 10 bis $3 \cdot 10^7$ eV.

Dieses Verfahren findet bei der Oberflächenmodifizierung von Heizelementen, die als Licht- und Wärmequellen in der Lichttechnik und in der Thermoelektrotechnik zum Ändern des Wirkungsgrades von Kathoden, Photodioden, Photokathoden, verwendet werden, sowie in der Optik zur Herstellung von Filtern und in der Optoelektronik zur Herstellung von Elementen mit bestimmter Wellenlänge Verwendung.

v. FÜNER    EBBINGHAUS    FINCK

PATENTANWÄLTE    EUROPEAN PATENT ATTORNEYS

MARIAHILFPLATZ 2 & 3, MÜNCHEN 90

POSTADRESSE: POSTFACH 95 01 60, D-8000 MÜNCHEN 95

EPAA-33553.5

24. Januar 1986

CUV "PROGRES"

## VERFAHREN ZUR HERSTELLUNG VON LICHT- UND WÄRME- QUELLEN MIT VERBESSERTER AUSSTRAHLFÄHIGKEIT

Die Erfindung betrifft ein Verfahren zum Ändern der Ausstrahlfähigkeit von Licht- und Wärmequellen, das zur Oberflächenmodifizierung (Änderung des Wirkungsgrades) von Heizelementen, die als Licht- und Wärmequellen in der Lichttechnik und in der Thermoelektrotechnik gebraucht werden, sowie in der Elektrotechnik und Elektronik zum Ändern des Wirkungsgrades von Kathoden, Photodioden, Photokathoden (in Photozellen, Photokopierern), in der Optik zur Herstellung von Filtern mit bestimmten Spektralcharakteristiken, in der Optoelektronik zur Herstellung von Elementen (Quellen und Empfänger) für spezielle Strahlung mit bestimmter Wellenlänge (Infrarot, Radio) usw. Verwendung findet.

Es sind Verfahren zur Verbesserung der mechanischen Haltbarkeit und Ausstrahlfähigkeit von Licht- und Wärmequellen bekannt (V.I. Gaponov, Elektronik, Band I, Fizmatgiz, 1960, S. 237-257; V.P. Denisov, Erzeugung von elektrischen Lichtquellen, Energia, Moskau, 1975, S. 28-101; V.S. Litvinov, G.N. Rochlin, Wärmequellen der optischen Ausstrahlung, Energia, Moskau, 1975, S. 10-20).

Diese Verfahren umfassen folgende Operationen:

- Herstellung von Fasern mit sehr großer Reinheit, was
infolge der hohen Temperaturen und der großen Aktivität
der Elemente bei diesen Temperaturen sehr kompliziert
ist;
- Entölen, d.h. ein Verfahren, bei dem die Fasern in organischen Lösungsmitteln gespült werden;
- Entgasen, d.h. dauerhafte Erwärmung im Vakuum;
- Oberflächenlegierung mit Oxiden von Erdalkalimetallen
usw.

Die Nachteile dieser bekannten Verfahren sind die geringe
Oberflächenkonzentration der Legierungszusätze, Schichtbildung und Abtrennung der Schichten, Zerstäubung, Vergiftung der Kathode und erschwerte technologische Reproduzierbarkeit.

Der Erfindung liegt die Aufgabe zugrunde, ein Verfahren
zum Ändern der Ausstrahlfähigkeit von Licht- und Wärmequellen zu schaffen, das universell und wirkungsvoll ist
und die Herstellung von Elementen mit besseren Eigenschaften der modifizierten Oberfläche ermöglicht.

Diese Aufgabe wird erfindungsgemäß durch die Anwendung
des Verfahrens der Ionen-Implantation auf eine Unterlage,
in welche Elemente mit passender Spektralverteilung implantiert werden, gelöst.

Gegenstand der Erfindung ist somit ein Verfahren zur Herstellung von Licht- und Wärmequellen mit verbesserter
Ausstrahlfähigkeit, dadurch gekennzeichnet, daß man chemische Elemente als Ionen in eine entsprechende Unterlage
in an sich bekannter Weise implantiert.

Die Implantation erfolgt im Vakuum von mehr als $10^{-4}$ Torr
bei der benötigten Temperatur der Unterlage: niedrige (Helium, Stickstoff), Zimmertemperatur und hohe Temperatur im Bereich der Haltbarkeit der Unterlage (Faden, Kathode, Rheotan).

Die Menge der implantierten Ionen (sogenannte Implantationsdosis) beträgt $10^{+10}$ bis $10^{+23}$ Ionen/cm². Die Ionenstromdichte beträgt $10^{-8}$ A/cm² bis 1 A/cm². Die Eindringtiefe des implantierten Ions erreicht $10^{-7}$ cm. Die Energie der Implantation beträgt 10 bis $3 \cdot 10^{7}$ eV.

Die Vorteile des erfindungsgemäßen Verfahrens sind folgende: Es wird eine zielgerichtete Änderung der Ausstrahlfähigkeit von Licht- und Wärmequellen in einem vorgegebenen Spektralbereich sowie eine genaue Reproduzierbarkeit der Arbeitsbedingungen und der Eigenschaften der Unterlage erreicht. Es ist ferner möglich, ein aufeinanderfolgendes Auftragen der Elemente durchzuführen, wodurch die Eigenschaften der Schicht verbessert werden. Die Quantität und die Reihenfolge hängen von den gewünschten Eigenschaften ab. Wenn nötig kann man eine absolute Reinheit (Isotopenstand) des implantierten Elements sichern, wobei sich das implantierte Element fest an das Unterlagematerial bindet unter Bildung neuer Strukturen. Demzufolge wird das Endprodukt nicht durch mechanische Beanspruchung beeinflußt (keine Risse, kein Bersten, kein Ablösen).

Bei der Modifizierung von Licht- und Wärmequellen werden Standard-Wolframfäden (Spirale) benutzt, in welchen geeignete chemische Elemente implantiert werden, um die Ausstrahlfähigkeit zu ändern.

Nach der Implantation sind Messungen an implantierten Fäden durchgeführt worden.

| | implantiertes chem. Element | Implantationsdosis (Ionen/cm²) | E (keV) | I (A/cm²) |
|---|---|---|---|---|
| Beispiel 1 | $Al^+$ | $5,5 \cdot 10^{16}$ | 55 | 6 |
| | $Si^+$ | $5,5 \cdot 10^{16}$ | 50 | 6 |
| Beispiel 2 | $Xe^+$ | $1 \cdot 10^{14}$ | 50 | 0,05 |
| | $N^+$ | $1 \cdot 10^{16}$ | 50 | 20 |
| | $Cr^+$ | $2 \cdot 10^{16}$ | 50 | 15 |
| | $Si^+$ | $6 \cdot 10^{16}$ | 50 | 4 |
| Beispiel 3 | $Xe^+$ | $1 \cdot 10^{14}$ | 50 | 0,05 |

Bei einem Arbeitsvakuum von $10^{-4}$ Torr zeigen die Ergebnisse für die erste Gruppe implantierter Elemente, daß, verglichen mit einem nicht implantierten Faden, eine Änderung der Ausstrahlfähigkeit des implantierten Fadens allgemein mit einem Zuwachs von 5 bis 45% im gemessenen Spektralbereich 300 bis 1100 nm verbunden ist.

In Beispiel 2 wird eine Abnahme der Ausstrahlfähigkeit in dem ganzen Spektralbereich 300 bis 1100 nm festgestellt.

Für die dritte Gruppe ist ein unterschiedlicher Gang der Änderung der Ausstrahlfähigkeit, gemessen im Bereich 300 bis 1100 nm, dargestellt.

Im Bereich von 420 bis 510 nm beträgt die Verminderung der Ausstrahlfähigkeit rund 30%, und im Bereich 670 bis 780 nm beträgt die Zunahme rund 10%.

Patentansprüche

1. Verfahren zur Herstellung von Licht- und Wärmequellen mit verbesserter Ausstrahlfähigkeit, d a d u r c h g e k e n n z e i c h n e t , daß man chemische Elemente als Ionen in eine entsprechende Unterlage in an sich bekannter Weise implantiert.

2. Verfahren nach Anspruch 1, dadurch g e k e n n - z e i c h n e t , daß man als Unterlage Fäden oder Fasern verwendet.

3. Verfahren nach einem der Ansprüche 1 oder 2, dadurch g e k e n n z e i c h n e t , daß man die Implantation in einem Vakuum von mehr als $10^{-4}$ Torr durchführt.

4. Verfahren nach einem der Ansprüche 1 bis 3, dadurch g e k e n n z e i c h n e t , daß man die Ionen in einer Menge von $10^{10}$ bis $10^{23}$ Ionen/cm² implantiert.

5. Verfahren nach einem der Ansprüche 1 bis 4, dadurch g e k e n n z e i c h n e t , daß man bei einer Ionenstromdichte von $10^{-8}$ bis 1 A/cm² arbeitet.

6. Verfahren nach einem der Ansprüche 1 bis 5, dadurch g e k e n n z e i c h n e t , daß die Energie der Implantation 10 bis $3 \cdot 10^7$ eV beträgt.